(19) **Europäisches Patentamt / European Patent Office / Office européen des brevets**

(11) **EP 1 801 783 B1**

(12) **EUROPEAN PATENT SPECIFICATION**

(45) Date of publication and mention
of the grant of the patent:
**19.08.2009   Bulletin 2009/34**

(51) Int Cl.:
*G10L 19/00* (2006.01)     *G10L 19/12* (2006.01)
*G10L 19/14* (2006.01)

(21) Application number: **05787917.3**

(22) Date of filing: **28.09.2005**

(86) International application number:
**PCT/JP2005/017838**

(87) International publication number:
**WO 2006/035810 (06.04.2006 Gazette 2006/14)**

(54) **SCALABLE ENCODING DEVICE, SCALABLE DECODING DEVICE, AND METHOD THEREOF**

EINRICHTUNG FÜR SKALIERBARE CODIERUNG, EINRICHTUNG FÜR SKALIERBARE DECODIERUNG UND VERFAHREN DAFÜR

DISPOSITIF DE CODAGE À ÉCHELON, DISPOSITIF DE DÉCODAGE À ÉCHELON ET MÉTHODE POUR CEUX-CI

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.09.2004   JP 2004288327**

(43) Date of publication of application:
**27.06.2007   Bulletin 2007/26**

(73) Proprietor: **Panasonic Corporation**
**Kadoma-shi**
**Osaka 571-8501 (JP)**

(72) Inventors:
• **GOTO, Michiyo**
**Osaka-shi**
**Osaka 540-6319 (JP)**
• **YOSHIDA, Koji**
**Osaka-shi**
**Osaka 540-6319 (JP)**
• **EHARA, Hiroyuki**
**Osaka-shi**
**Osaka 540-6319 (JP)**
• **OSHIKIRI, Masahiro**
**Osaka-shi**
**Osaka 540-6319 (JP)**

(74) Representative: **Grünecker, Kinkeldey,**
**Stockmair & Schwanhäusser**
**Anwaltssozietät**
**Leopoldstrasse 4**
**80802 München (DE)**

(56) References cited:
**WO-A-02/23529          JP-A- 6 222 797**
**JP-A- 6 259 097          JP-A- 9 261 065**
**JP-A- 10 105 193          JP-A- 10 143 199**
**JP-A- 2003 099 095          JP-A- 2003 323 199**
**US-B1- 6 629 078**

• **GOTO M ET AL: "Onsei Tsushinyo Scalable Stereo Onsei Fugoka Hoho no Kento /A STUDY OF SCALABLE STEREO SPEECH CODING FOR SPEECH COMMUNICATIONS" FORUM ON INFORMATION TECHNOLOGY IPPAN KOEN RONBUNSHU, XX, XX, no. G-17, 22 August 2005 (2005-08-22), pages 299-300, XP003011997**
• **RAMPRASHAD S A: "Stereophonic celp coding using cross channel prediction" SPEECH CODING, 2000. PROCEEDINGS. 2000 IEEE WORKSHOP ON SEPTEMBER 17-20, 2000, PISCATAWAY, NJ, USA, IEEE, 17 September 2000 (2000-09-17), pages 136-138, XP010520067 ISBN: 0-7803-6416-3**

**Description**

Technical Field

The present invention relates to a scalable encoding apparatus that performs scalable encoding on a stereo speech signal using a CELP method (hereinafter referred to simply as CELP encoding), a scalable decoding apparatus, and a method used by the scalable encoding apparatus and scalable decoding apparatus.

Background Art

In speech communication of a mobile communication system, communication using a monaural scheme (monaural communication) is a mainstream, such as communication using mobile telephones. However, if a transmission rate increases further as in the fourth-generation mobile communication system, it is possible to maintain an adequate bandwidth for transmitting a plurality of channels. It is therefore expected that communication using a stereo system (stereo communication) will be widely used in speech communication as well.

For example, considering the increasing number of users who enjoy stereo music by storing music in portable audio players that are equipped with a HDD (hard disk) and attaching stereo earphones, headphones, or the like to the player, it is anticipated that mobile telephones will be combined with music players in the future, and that a lifestyle of using stereo earphones, headphones, or other equipments and performing speech communication using a stereo system will become prevalent. In order to realize realistic conversation in the environment such as in currently popularized TV conference, it is anticipated that stereo communication is used.

Even when stereo communication becomes common, it is assumed that monaural communication will also be used. This is because monaural communication has a low bit rate, and a lower cost of communication can therefore be expected. Further, a mobile telephone which supports only monaural communication has a smaller circuit scale and is therefore inexpensive. Users who do not need high-quality speech communication will purchase mobile telephones which support only monaural communication. Accordingly, in a single communication system, mobile telephones which support stereo communication and mobile telephones which support monaural communication will coexist. Therefore, the communication system will have to support both stereo communication and monaural communication.

In the mobile communication system, communication data is exchanged using radio signals, a part of the communication data is sometimes lost according to the propagation path environment. Therefore, if the mobile telephone has a function of restoring the original communication data from the residual received data even in this case, it is extremely useful.

There is scalable encoding composed of a stereo signal and a monaural signal. This type of encoding can support both stereo communication and monaural communication and is capable of restoring the original communication data from residual received data even when a part of the communication data is lost. An example of a scalable encoding apparatus that has this function is disclosed in Non-patent Document 1, for example.

Non-patent Document 1: ISO/IEC 14496-3:1999 (B.14 Scalable AAC with core coder)

WO 0223529 A1 relates to multi-channel signal encoding and decoding. The multi-channel linear predictive analysis-by-synthesis signal encoding method determines a leading channel and encodes the leading channel as an embedded bitstream. Thereafter trailing channels are encoded as a discardable bitstream exploiting cross-correlation to the leading channel.

Disclosure of Invention

Problems to Be Solved by the Invention

However, the scalable encoding apparatus disclosed in Non-patent Document 1 is designed for an audio signal and does not assume a speech signal, and therefore there is a problem of decreasing encoding efficiency when the scalable encoding is applied to a speech signal as is. Specifically, for a speech signal, it is required to apply CELP encoding which is capable of efficient encoding, but Non-patent Document 1 does not disclose the specific configuration for the case where a CELP method is applied, particularly where CELP encoding is applied in an extension layer. Even when CELP encoding optimized for the speech signal which is not assumed to that apparatus is applied as is, the desired encoding efficiency is difficult to obtain.

It is therefore an object of the present invention to provide a scalable encoding apparatus capable of realizing scalable encoding of a stereo speech signal using a CELP method and improving encoding efficiency, a scalable decoding apparatus, and a method used by the scalable encoding apparatus and scalable decoding apparatus.

Means for Solving the Problem

This object is solved by the invention as claimed in the independent claims. Preferred embodiments of the invention are defined by the dependent claims.

According to the present invention, it is possible to perform scalable encoding of a stereo speech signal using CELP encoding and improve encoding efficiency.

Brief Description of Drawings

FIG.1 is a block diagram showing the main configuration of the scalable encoding apparatus according to embodiment 1;

FIG.2 shows the relationship of the monaural signal, the first channel signal and the second channel signal;

FIG.3 is a block diagram showing the main internal configuration of the monaural signal CELP encoder according to embodiment 1;

FIG.4 is a block diagram showing the main internal configuration of the first channel signal encoder according to embodiment 1;

FIG.5 is a block diagram showing the main configuration of the scalable decoding apparatus according to embodiment 1;

FIG.6 is a block diagram showing the main configuration of the scalable encoding apparatus according to embodiment 2;

FIG.7 is a block diagram showing the main internal configuration of the first channel signal encoder according to embodiment 2; and

FIG.8 is a block diagram showing the main configuration of the scalable decoding apparatus according to embodiment 2.

Best Mode for Carrying Out the Invention

Embodiments of the present invention will be described in detail hereinafter with reference to the accompanying drawings. The case will be described as an example where the stereo speech signal formed with two channels is encoded, wherein the first channel and the second channel described hereinafter are an L channel and an R channel, respectively, or an R channel and an L channel, respectively.

(Embodiment 1)

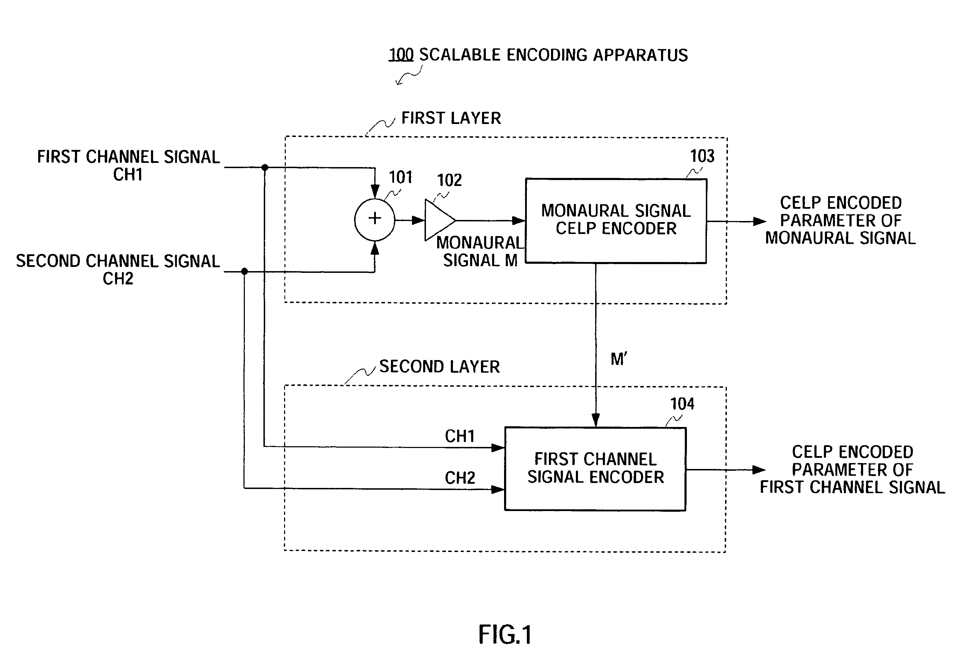

FIG.1 is a block diagram showing the main configuration of scalable encoding apparatus 100 according to embodiment 1 of the present invention. Scalable encoding apparatus 100 is provided with adder 101, multiplier 102, monaural signal CELP encoder 103 and first channel signal encoder 104.

Each section of scalable encoding apparatus 100 performs the operation described below.

Adder 101 adds first channel signal CH1 and second channel signal CH2 which are inputted to scalable encoding apparatus 100 to generate a sum signal. Multiplier 102 multiplies the sum signal by 1/2 to divide the scale in half and generates monaural signal M. Specifically, adder 101 and multiplier 102 calculate the average signal of first channel signal CH1 and second channel signal CH2 and set the average signal as monaural signal M.

Monaural signal CELP encoder 103 performs CELP encoding on monaural signal M and outputs a CELP encoded parameter obtained for each sub-frame to outside of scalable encoding apparatus 100. Monaural signal CELP encoder 103 outputs synthesized monaural signal M', which is synthesized (for each sub-frame) using the CELP encoded parameter for each sub-frame, to first channel signal encoder 104. The term "CELP encoded parameter" used herein is an LPC (LSP) parameter, an adaptive excitation codebook index, an adaptive excitation gain, a fixed excitation codebook index and a fixed excitation gain.

First channel signal encoder 104 performs encoding described later on first channel signal CH1 inputted to scalable encoding apparatus 100 using second channel signal CH2 inputted to scalable encoding apparatus 100 in the same way and synthesized monaural signal M' outputted from monaural signal CELP encoder 103, and outputs the CELP encoded parameter of the obtained first channel signal to outside of scalable encoding apparatus 100.

One of the characteristics of scalable encoding apparatus 100 is that adder 101, multiplier 102, and monaural signal CELP encoder 103 form a first layer, and first channel signal encoder 104 forms a second layer, wherein the encoded parameter of the monaural signal is outputted from the first layer, and the encoded parameter with which a stereo signal can be obtained by decoding together with a decoded signal of the first layer (monaural signal) at the decoding side is outputted from the second layer. Specifically, the scalable encoding apparatus according to this embodiment performs scalable encoding that is composed of a monaural signal and a stereo signal.

According to this configuration, the decoding apparatus which acquires the encoded parameters composed of the abovementioned first layer and second layer can decode a monaural signal although at a low quality, even if the decoding apparatus cannot acquire the encoded parameter of the second layer and can only acquire the encoded parameter of the first layer due to deterioration of the transmission path environment. When the decoding apparatus can acquire the encoded parameters of the first layer and second layer, it is possible to decode a stereo signal at a high quality using these parameters.

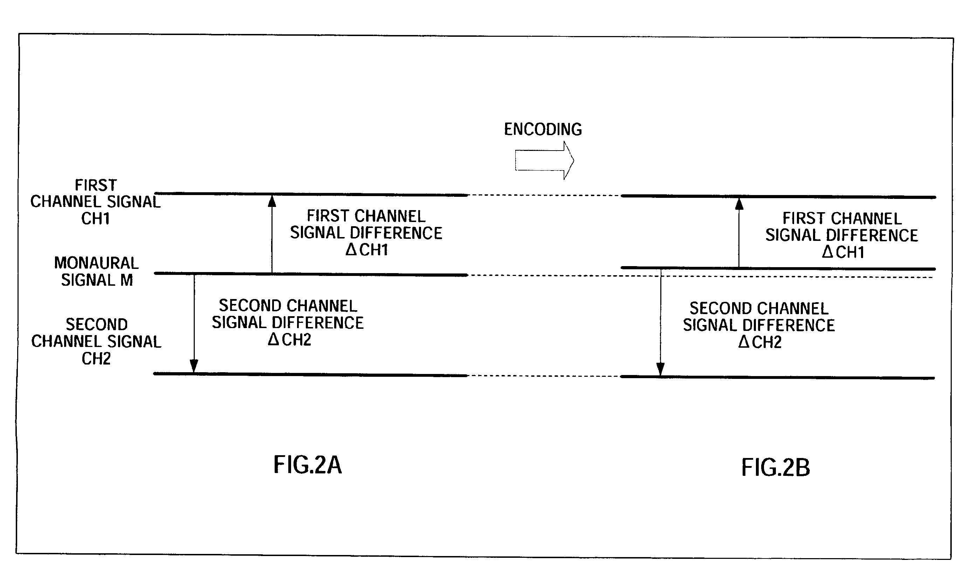

The principle by which the decoding apparatus can decode a stereo signal using the encoded parameters of the first layer and second layer outputted from scalable encoding apparatus 100 will be described hereinafter. FIG. 2 shows the relationship of the monaural signal, the first channel signal and the second channel signal.

As shown in FIG.2A, monaural signal M prior to encoding can be calculated by multiplying the sum of first channel signal CH1 and second channel signal CH2 by 1/2, that is, by the following Equation (1).

$$M = (CH1 + CH2)/2 \quad (Equation\ 1)$$

Therefore, second channel signal CH2 can be calculated when monaural signal M and first channel signal CH1 are known.

However, in reality, when monaural signal M and first channel signal CH1 are encoded, encoding distortion occurs as a result of encoding, and therefore, Equation (1) no longer holds. More specifically, when the difference between first channel signal CH1 and monaural signal M is referred to as first channel signal difference $\Delta CH1$, and the difference between second channel signal CH2 and monaural signal M is referred to as second channel signal difference $\Delta CH2$, a difference occurs between $\Delta CH1$ and $\Delta CH2$ as shown in FIG.2B as a result of encoding, and the relationship of Equation (1) is no longer satisfied. Therefore, even when monaural signal M and first channel signal CH1 can be obtained by decoding, it is subsequently no longer possible to correctly calculate second channel signal CH2. In order to prevent the degradation of the speech quality of the decoded signal, it is necessary to consider an encoding method taking into consideration the difference between the two encoding distortions.

In order to further improve the decoding accuracy of CH1 and CH2, scalable encoding apparatus 100 according to this embodiment minimizes the encoding distortion of CH1 upon encoding of CH1 so that the encoding distortion of CH2 is minimized, and determines the encoded parameter of CH1. By this means, it is possible to prevent the degradation of the speech quality of the decoded signal.

On the other hand, the decoded CH2 is generated in the decoding apparatus from the decoded signal of CH1 and the decoded signal of the monaural signal. Equation (2) below is obtained from the above Equation (1), and CH2 can therefore be generated according to Equation (2).

$$CH2 = 2 \times M - CH1 \quad (Equation\ 2)$$

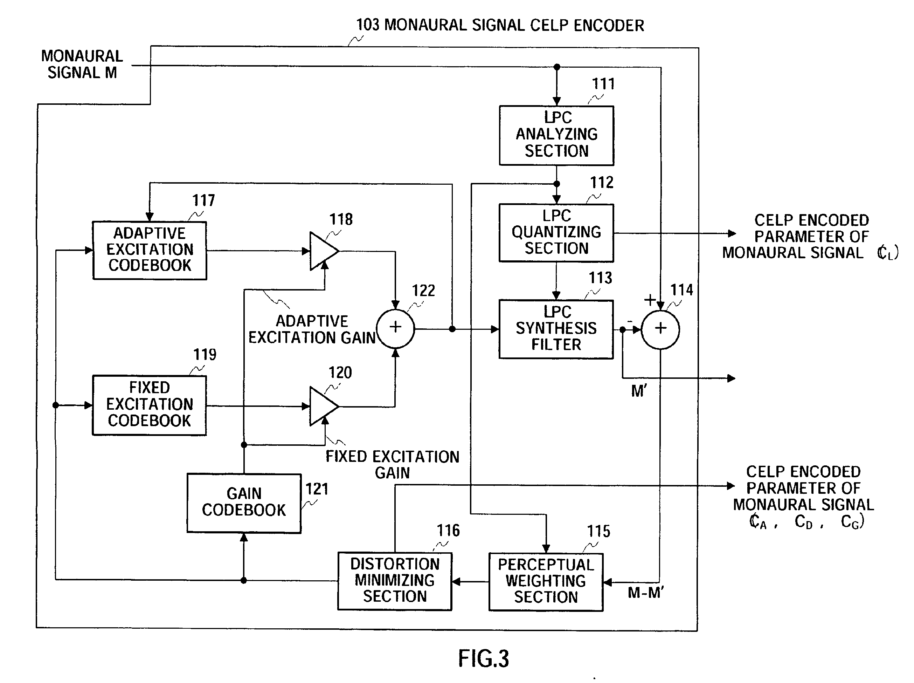

FIG. 3 is a block diagram showing the main internal configuration of monaural signal CELP encoder 103.

Monaural signal CELP encoder 103 is provided with LPC analyzing section 111, LPC quantizing section 112, LPC synthesis filter 113, adder 114, perceptual weighting section 115, distortion minimizing section 116, adaptive excitation codebook 117, multiplier 118, fixed excitation codebook 119, multiplier 120, gain codebook 121 and adder 122.

LPC analyzing section 111 performs linear prediction analysis on monaural signal M outputted from multiplier 102, and outputs the LPC parameter which is the analysis result to LPC quantizing section 112 and perceptual weighting section 115.

LPC quantizing section 112 quantizes the LSP parameter after converting the LPC parameter outputted from LPC analyzing section 111 to an LSP parameter which is suitable for quantization, and outputs the obtained quantized LSP parameter (CL) to outside of monaural signal CELP encoder 103. The quantized LSP parameter is one of the CELP encoded parameters obtained by monaural signal CELP encoder 103. LPC quantizing section 112 reconverts the quantized LSP parameter to a quantized LPC parameter, and outputs the quantized LPC parameter to LPC synthesis filter 113.

LPC synthesis filter 113 uses the quantized LPC parameter outputted from LPC quantizing section 112 to perform synthesis by LPC synthesis filter using an excitation vector generated by adaptive excitation codebook 117 and fixed excitation codebook 119 (described hereinafter) as excitation. The obtained synthesized signal M' is outputted to adder 114 and first channel signal encoder 104.

Adder 114 inverts the polarity of the synthesized signal outputted from LPC synthesis filter 113, calculates an error signal by adding to monaural signal M, and outputs the error signal to perceptual weighting section 115. This error signal corresponds to the encoding distortion.

Perceptual weighting section 115 uses a perceptual weighting filter configured based on the LPC parameter outputted from LPC analyzing section 111 to perform perceptual weighting for the encoding distortion outputted from adder 114, and the signal is outputted to distortion minimizing section 116.

Distortion minimizing section 116 indicates various types of parameters to adaptive excitation codebook 117, fixed excitation codebook 119 and gain codebook 121 so as to minimize the encoding distortion that is outputted from perceptual weighting section 115. Specifically, distortion minimizing section 116 indicates indices $(C_A, C_D, C_G)$ to adaptive excitation codebook 117, fixed excitation codebook 119 and gain codebook 121.

Adaptive excitation codebook 117 stores the previously generated excitation vector for LPC synthesis filter 113 in an internal buffer, generates a single sub-frame portion from the stored excitation vector based on an adaptive excitation lag that corresponds to the index indicated from distortion minimizing section 116, and outputs the single sub-frame portion to multiplier 118 as an adaptive excitation vector.

Fixed excitation codebook 119 outputs the excitation vector, which corresponds to the index indicated from distortion minimizing section 116, to multiplier 120 as a fixed excitation vector.

Gain codebook 121 generates a gain that corresponds to the index indicated from distortion minimizing section 116, that is, a gain for the adaptive excitation vector from adaptive excitation codebook 117, and a gain for the fixed excitation vector from fixed excitation codebook 119, and outputs the gains to multipliers 118 and 120.

Multiplier 118 multiplies the adaptive excitation gain outputted from gain codebook 121 by the adaptive excitation vector outputted from adaptive excitation codebook 117, and outputs the result to adder 122.

Multiplier 120 multiplies the fixed excitation gain outputted from gain codebook 121 by the fixed excitation vector outputted from fixed excitation codebook 119, and outputs the result to adder 122.

Adder 122 adds the adaptive excitation vector outputted from multiplier 118 and the fixed excitation vector outputted from multiplier 120, and outputs the added excitation vector as excitation to LPC synthesis filter 113. Adder 122 also feeds back the obtained excitation vector of the excitation to adaptive excitation codebook 117.

As previously described, the excitation vector outputted from adder 122, that is, the excitation vector generated by adaptive excitation codebook 117 and fixed excitation codebook 119, is synthesized as excitation by LPC synthesis filter 113.

In this way, a series of processing of obtaining the encoding distortion using the excitation vectors generated by adaptive excitation codebook 117 and fixed excitation codebook 119 is a closed loop (feedback loop). Distortion minimizing section 116 indicates adaptive excitation codebook 117, fixed excitation codebook 119, and gain codebook 121 so as to minimize the encoding distortion. Distortion minimizing section 116 outputs various types of CELP encoded parameters $(C_A, C_D, C_G)$ that minimize the encoding distortion to outside of scalable encoding apparatus 100.

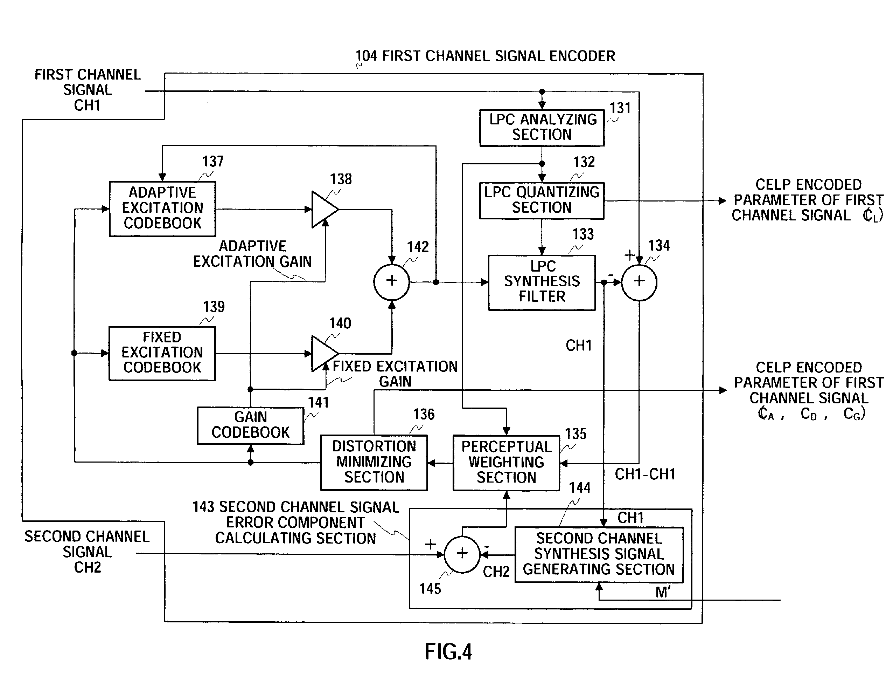

FIG. 4 is a block diagram showing the main internal configuration of first channel signal encoder 104.

In first channel signal encoder 104, the configurations of LPC analyzing section 131, LPC quantizing section 132, LPC synthesis filter 133, adder 134, distortion minimizing section 136, adaptive excitation codebook 137, multiplier 138, fixed excitation codebook 139, adder 140, gain codebook 141 and adder 142 are the same as those of LPC analyzing section 111, LPC quantizing section 112, LPC synthesis filter 113, adder 114, distortion minimizing section 116, adaptive excitation codebook117, multiplier118, fixed excitation codebook 119, multiplier 120, gain codebook 121 and adder 122 in monaural signal CELP encoder 103. These components are therefore not described.

Second channel signal error component calculating section 143 is an entirely new component. The basic operations of perceptual weighting section 135 and distortion minimizing section 136 are the same as those of perceptual weighting section 115 and distortion minimizing section 116 in monaural signal CELP encoder 103. However, perceptual weighting section 135 and distortion minimizing section 136 receive the output of second channel signal error component calculating section 143 and perform operations that differ from those of monaural signal CELP encoder 103 as described below.

When CH1 is encoded in a second layer, that is, in first channel signal encoder 104, scalable encoding apparatus 100 according to this embodiment decides an encoded parameter of CH1 so as to minimize the sum of the encoding distortion of CH1 and the encoding distortion of CH2. A high-quality speech can thereby be achieved by simultaneously optimizing the encoding distortions of CH1 and CH2.

Second channel signal error component calculating section 143 calculates an error component for a case where CELP encoding is temporarily performed on the second channel signal, that is, calculates the above-described encoding distortion of CH2. Specifically, second channel synthesis signal generating section 144 in second channel signal error component calculating section 143 calculates a synthesized second channel signal CH2' by doubling synthesized monaural signal M' and subtracting synthesized first channel signal CH1' from the calculated value. Second channel synthesis signal generating section 144 does not perform CELP encoding of the second channel signal. Adder 145 then calculates the difference between second channel signal CH2 and synthesized second channel signal CH2'.

Perceptual weighting section 135 performs perceptual weighting on the difference between first channel signal CH1 and synthesized first channel signal CH1', that is, the encoding distortion of the first channel, in the same way as perceptual weighting section 115 in monaural signal CELP encoder 103. Perceptual weighting section 135 also performs perceptual weighting of the difference between second channel signal CH2 and synthesized second channel signal CH2', that is, the encoding distortion of the second channel.

Distortion minimizing section 136 decides the optimal adaptive excitation vector, the fixed excitation vector and the gain of the vectors using the algorithm described below so as to minimize the perceptual-weighted encoding distortion, that is, the sum of the encoding distortion for the first channel signal and the encoding distortion for the second channel signal.

Hereinafter, the algorithm used in distortion minimizing section 136 which minimizes encoding distortion will be described. CH1 and CH2 are input signals, CH1' is the synthesized signal of CH1, CH2' is the synthesized signal of CH2, and M' is the synthesized monaural signal.

Sum d of the encoding distortions of the first channel signal and the second channel signal can be expressed by Equation (3) below.

$$d = \| CH1 - CH1' \|^2 + \| CH2 - CH2' \|^2 \quad (Equation\ 3)$$

From the relationship of the monaural signal, the first channel signal and the second channel signal, CH2' can be expressed by already-encoded monaural synthesized signal M' and first channel synthesized signal CH1' as shown in Equation (4) below.

$$CH2' = 2 \times M' - CH1' \quad (Equation\ 4)$$

Equation (3) can thus be rewritten as Equation (5) below.

$$d = \| CH1 - CH1' \|^2 + \| CH2 - (2 \times M' - CH1') \|^2 \quad (Equation\ 5)$$

Specifically, the scalable encoding apparatus according to this embodiment obtains through search the CELP encoded parameter of the first channel signal for obtaining CH1' that minimizes encoding distortion d expressed by Equation (5).

Specifically, the LPC parameter for the first channel is first analyzed/quantized. The adaptive excitation codebook, the fixed excitation codebook and the excitation gain are then searched so as to minimize the encoding distortion expressed by Equation (5) above, and an adaptive excitation codebook index, a fixed excitation codebook index and an excitation gain index are determined.

Specifically, although the sum of the encoding distortion of CH1 and the encoding distortion of CH2 is minimized, it is only necessary to consider the encoding distortion of CH1 in the process of encoding. The encoding distortion for CH2 is thereby simultaneously considered.

By optimizing the encoding (adaptive excitation codebook index and fixed excitation codebook index) of the first channel parameter, it is possible to perform encoding so as to minimize the encoding distortion not only for the first channel signal, but also for the second channel signal.

Another variation of the algorithm used in distortion minimizing section 136 that minimizes the encoding distortion will next be described. A case will be described where the encoding distortion of the first channel signal and the encoding distortion of the second channel signal are weighted in accordance with the degree of accuracy when it is desired that the encoding distortion of the first channel signal and the encoding distortion of the second channel signal are perceptual-weighted at perceptual weighting section 135, and either of the channel signals is encoded at high accuracy. Herein, α and β are weighting coefficients with respect to the encoding distortion of perceptual-weighted CH1 and CH2, respectively.

Sum d' of the encoding distortions for the first channel signal and the second channel signal is expressed by Equation (6) below.

$$d'=\alpha \times \| CH1-CH1' \|^2 + \beta \times \| CH2 - CH2' \|^2 \quad (Equation\ 6)$$

From the relationship of the monaural signal, the first channel signal and the second channel signal, CH2' can be expressed by already-encoded monaural synthesized signal M' and first channel synthesized signal CH1' as shown in Equation (7) below.

$$CH2' = 2 \times M' - CH1' \quad (Equation\ 7)$$

Equation (6) thus becomes Equation (8) below.

$$d'=\alpha \times \| CH1 - CH1' \|^2 + \beta \times \| CH2 - (2 \times M' - CH1') \|^2$$

$$(Equation\ 8)$$

The scalable encoding apparatus according to this embodiment obtains through search the first channel CELP encoded parameter so as to obtain CH1' that minimizes encoding distortion d' expressed by Equation (8).

Specifically, the LPC parameter for the first channel is first analyzed/quantized. The adaptive excitation codebook, the fixed excitation codebook and the excitation gain are then searched so as to minimize the encoding distortion expressed by Equation (8) above, and an adaptive excitation codebook index, a fixed excitation codebook index and a excitation gain index are determined.

Specifically, although the sum of the encoding distortion of CH1 and the encoding distortion of CH2 is minimized, it is only necessary to consider the encoding distortion of CH1 in the process of encoding. The encoding distortion for CH2 is thereby simultaneously considered.

Simultaneous consideration herein does not necessarily mean that the encoding distortions are considered in equal ratios. For example, when the first channel signal and the second channel signal are completely independent signals (for example, a speech signal and a separate music signal, the speech by person A and the speech by person B, or another case), and higher accuracy encoding of the first channel signal is desired, by setting weighting coefficient α for the distortion signal of the first channel signal so as to be larger than β, it is possible to make the distortion of the first channel signal smaller than the second channel signal.

In this way, by optimizing the encoding (adaptive excitation codebook index and fixed excitation codebook index) of the first channel parameter, it is possible to perform encoding so as to minimize the encoding distortion not only for the first channel signal, but also for the second channel signal.

The values of α and β may be determined by preparing the values in advance in a table according to a type of the input signal (such as a speech signal and a music signal), or the values may be determined by calculating an energy ratio of signals in a fixed interval (such as frame and sub-frame).

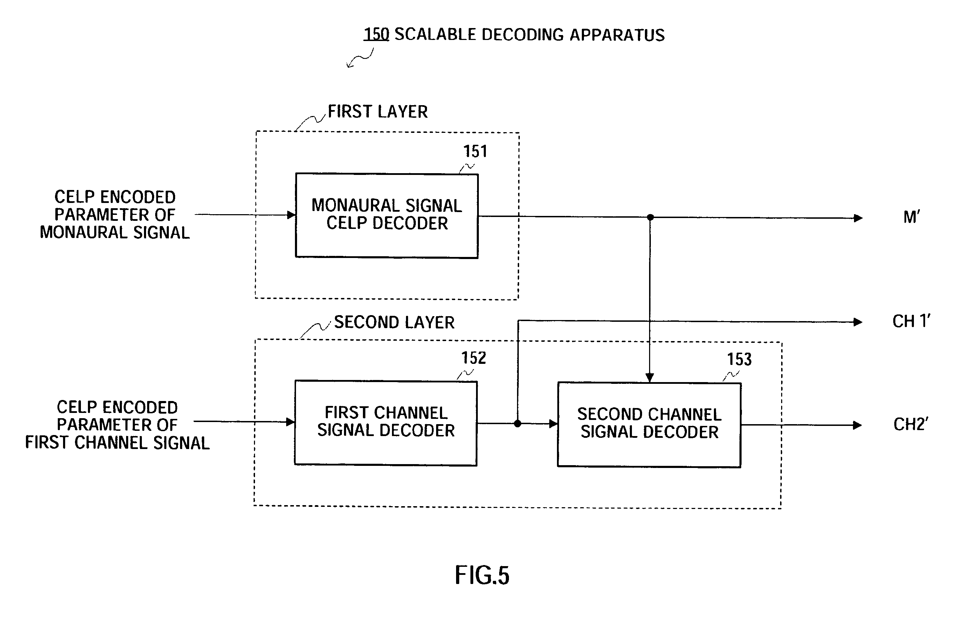

FIG.5 is a block diagram showing the main configuration of scalable decoding apparatus 150 that decodes the encoded parameter generated by scalable encoding apparatus 100, that is, corresponds to scalable encoding apparatus 100.

Monaural signal CELP decoder 151 synthesizes monaural signal M' from the CELP encoded parameter of the monaural signal. First channel signal decoder 152 synthesizes the first channel signal CH1' from the CELP encoded parameter of the first channel signal.

Second channel signal decoder 153 calculates second channel signal CH2' according to Equation (9) below from monaural signal M' and first channel signal CH1'.

$$CH2' = 2 \times M' - CH1' \quad (Equation\ 9)$$

According to this embodiment, when CH1 is encoded, the encoded parameter of CH1 is determined so as to minimize the sum of the encoding distortion of CH1 and the encoding distortion of CH2, so that it is possible to improve the decoding accuracy of CH1 and CH2 and prevent the degradation of the speech quality of the decoded signal.

In this embodiment, the encoded parameter of CH1 is determined so as to minimize the sum of the encoding distortion of CH1 and the encoding distortion of CH2, but the encoded parameter of CH1 may also be determined so as to minimize both the encoding distortion of CH1 and the encoding distortion of CH2.

(Embodiment 2)

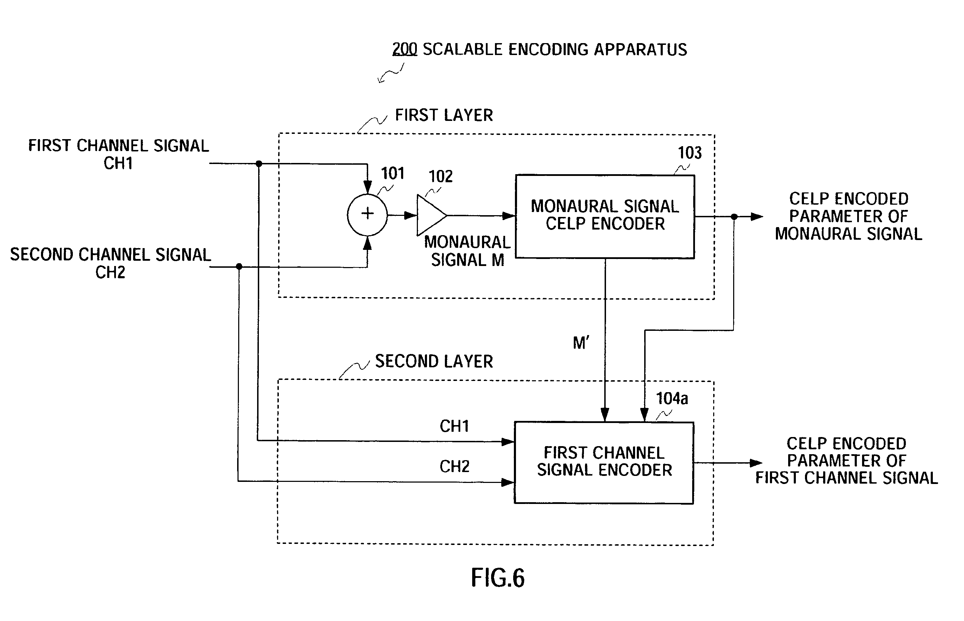

FIG.6 is a block diagram showing the main configuration of scalable encoding apparatus 200 according to embodiment 2 of the present invention. Scalable encoding apparatus 200 has the same basic configuration as scalable encoding apparatus 100 of embodiment 1. Components that are the same will be assigned the same reference numerals without further explanations.

In this embodiment, when CH1 is encoded in the second layer, a difference parameter of CH1 relative to the monaural signal is encoded. More specifically, first channel signal encoder 104a performs encoding in accordance with CELP encoding, that is, encoding using linear prediction analysis and adaptive excitation codebook search, on the first channel signal CH1 inputted to scalable encoding apparatus 200, and obtains a difference parameter between an encoded parameter obtained in the process and a CELP encoded parameter of the monaural signal outputted from monaural signal CELP encoder 103. When this encoding is also referred to simply as CELP encoding, the above-described processing corresponds to obtaining a difference in the level (stage) of the CELP encoded parameter for monaural signal M and first channel signal CH1. First channel signal encoder 104a encodes the above-described difference parameter. By this means, the difference parameter is quantized, so that it is possible to perform more efficient encoding.

In the same way as in embodiment 1, monaural signal CELP encoder 103 performs CELP encoding on the monaural signal generated from the first channel signal and the second channel signal, and extracts and outputs a CELP encoded parameter of the monaural signal. The CELP encoded parameter of the monaural signal is also inputted to first channel signal encoder 104a. Monaural signal CELP encoder 103 also outputs synthesized monaural signal M' to first channel signal encoder 104a.

The input of first channel signal encoder 104a is first channel signal CH1, second channel signal CH2, synthesized monaural signal M', and the CELP encoded parameter of the monaural signal. First channel signal encoder 104a encodes the difference between the first channel signal and the monaural signal and outputs the CELP encoded parameter of the first channel signal. The monaural signal herein is already CELP-encoded, and the encoded parameter is extracted. Therefore, the CELP encoded parameter of the first channel signal is the difference parameter with respect to the CELP encoded parameter of the monaural signal.

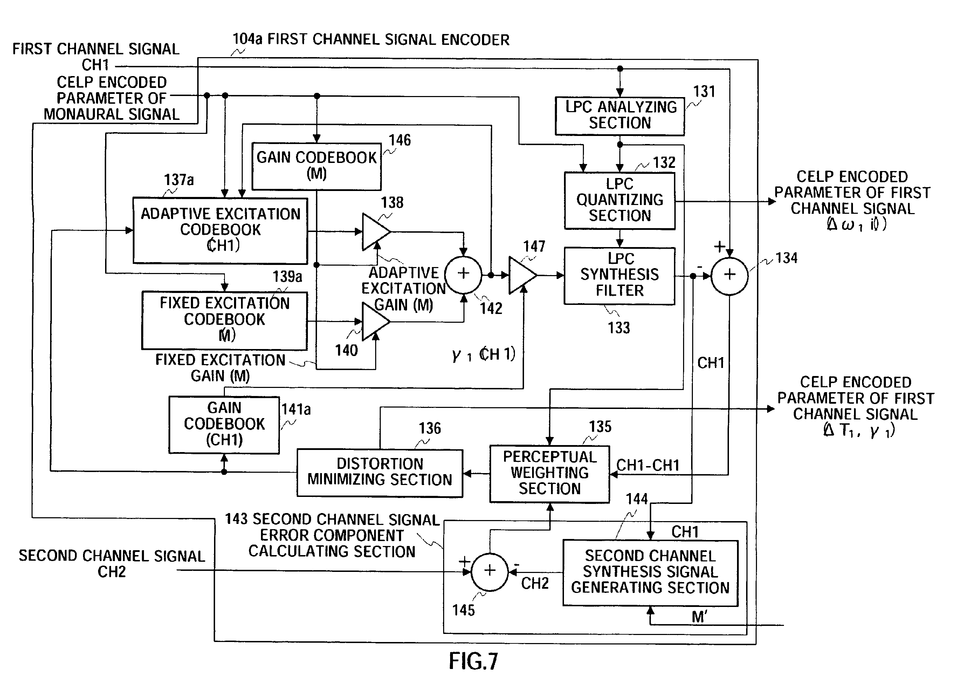

FIG. 7 is a block diagram showing the main internal configuration of first channel signal encoder 104a.

LPC quantizing section 132 calculates the difference LPC parameter between an LPC parameter of first channel signal CH1 obtained by LPC analyzing section 131 and an LPC parameter of the monaural signal already calculated by monaural signal CELP encoder 103, and quantizes the difference to obtain the final LPC parameter of the first channel.

The excitation is searched as follows. Adaptive excitation codebook 137a indicates the adaptive codebook lag of first channel CH1 as the adaptive codebook lag of the monaural signal and a difference lag parameter with respect to the adaptive codebook lag of the monaural signal. Fixed excitation codebook 139a uses the fixed excitation codebook index for monaural signal M which is used in fixed excitation codebook 119 of monaural signal CELP encoder 103A, as the fixed excitation codebook index of CH1. Specifically, fixed excitation codebook 139a uses the same index as that obtained in encoding of the monaural signal as the fixed excitation vector.

The excitation gain is expressed by the product of the adaptive excitation gain obtained by encoding monaural signal M, and a gain multiplier multiplied by the adaptive excitation gain; or the product of the fixed excitation gain obtained by encoding monaural signal M, and a gain multiplier (which is the same as that multiplied by the adaptive excitation gain) to be multiplied by the fixed excitation gain. This gain multiplier is encoded.

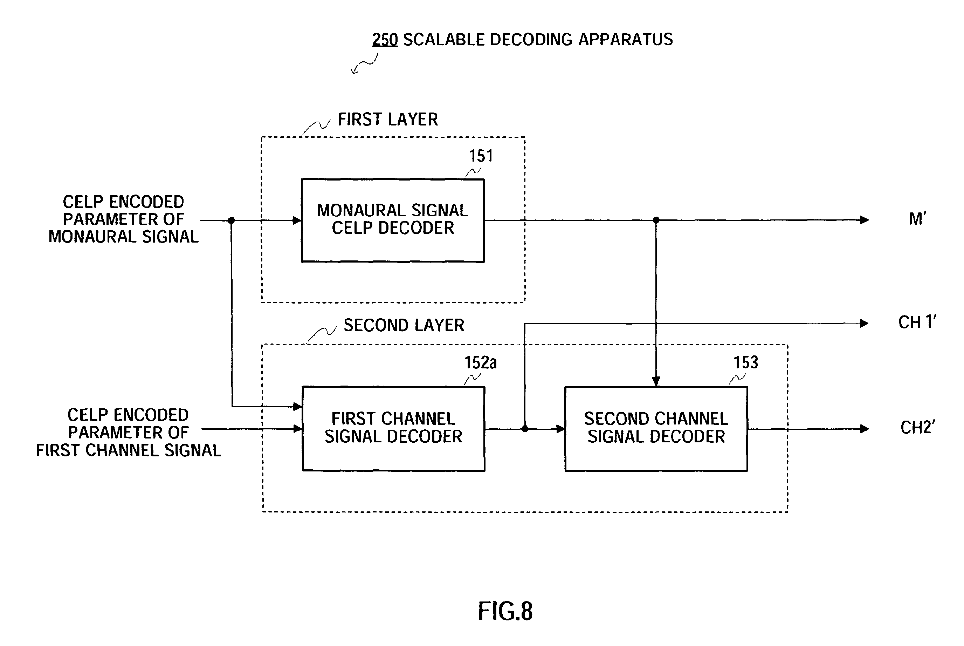

FIG.8 is a block diagram showing the main configuration of scalable decoding apparatus 250 that corresponds to scalable encoding apparatus 200 described above.

First channel signal decoder 152a synthesizes first channel signal CH1' from both the CELP encoded parameter of the monaural signal and the CELP encoded parameter of the first channel signal.

In this way, according to this embodiment, when CH1 is encoded in the second layer, the difference parameter relative to the monaural signal is encoded, so that it is possible to perform more efficient encoding.

Embodiments 1 and 2 according to the present invention were described above.

The scalable encoding apparatus and scalable decoding apparatus according to the present invention are not limited to the embodiments described above, and may include various types of modifications.

The scalable encoding apparatus and scalable decoding apparatus according to the present invention can also be provided in a communication terminal apparatus and a base station apparatus in a mobile communication system. By this means, it is possible to provide a communication terminal apparatus and a base station apparatus that have the same operational advantages as those described above.

In the embodiments described above, monaural signal M was the average signal of CH1 and CH2, but this is by no means limiting.

The adaptive excitation codebook is also sometimes referred to as an adaptive codebook. The fixed excitation codebook is also sometimes referred to as a fixed codebook, a noise codebook, a stochastic codebook or a random codebook.

The case has been described as an example where the present invention is implemented with hardware, the present invention can be implemented with software.

Furthermore, each function block used to explain the above-described embodiments is typically implemented as an LSI constituted by an integrated circuit. These may be individual chips or may partially or totally be contained on a single chip.

Here, each function block is described as an LSI, but this may also be referred to as "IC", "system LSI", "super LSI", "ultra LSI" depending on differing extents of integration.

Further, the method of circuit integration is not limited to LSIs, and implementation using dedicated circuitry or general purpose processors is also possible. After LSI manufacture, utilization of a programmable FPGA (Field Programmable Gate Array) or a reconfigurable processor in which connections and settings of circuit cells within an LSI can be reconfigured is also possible.

Further, if integrated circuit technology comes out to replace LSIs as a result of the development of semiconductor technology or a derivative other technology, it is naturally also possible to carry out function block integration using this technology. Application in biotechnology is also possible.

Industrial Applicability

The scalable encoding apparatus, scalable decoding apparatus, and method according to the present invention can be applied to a communication terminal apparatus, a base station apparatus, or other apparatus that perform scalable encoding on a stereo signal using CELP encoding in a mobile communication system.

**Claims**

1. A scalable encoding apparatus comprising:

   a generating section that is adapted to generate a monaural speech signal from a stereo speech signal that includes a first channel signal and a second channel signal;
   a monaural encoding section that is adapted to encode the monaural speech signal using a CELP method;
   a calculating section that is adapted to generate a synthesized second channel signal using a synthesized monaural signal provided by the monaural encoding section and a synthesized first channel signal, to calculate a difference between the second channel signal and the synthesized second channel signal, and thereby to calculate encoding distortion of the second channel signal that is caused by the CELP method used in the monaural encoding section; and
   a first channel encoding section that is adapted to encode the first channel signal using the CELP method and to obtain a CELP encoded parameter of the first channel signal so as to minimize the sum of the encoding distortion of the first channel signal that is caused by the CELP method used in the first channel encoding section, and the encoding distortion of the second channel signal calculated by the calculating section.

2. The scalable encoding apparatus according to claim 1, wherein:

   the monaural encoding section is adapted to generate the synthesized monaural signal using an encoded parameter obtained by encoding the monaural speech signal using the CELP method;
   the first channel encoding section is adapted to generate a synthesized first channel signal using the CELP encoded parameter obtained by encoding the first channel signal using the CELP method.

3. The scalable encoding apparatus according to claim 1, wherein the sum is a sum of the weighted distortion of the encoding distortion of the first channel signal and the encoding distortion of the second channel signal.

4. The scalable encoding apparatus according to claim 1, wherein:

   the monaural encoding section is adapted to output a CELP encoded parameter obtained by performing linear prediction analysis on the monaural speech signal to the first channel encoding section; and
the first channel encoding section is adapted to encode a difference between the CELP encoded parameter obtained by performing linear prediction analysis on the first channel signal, and the CELP encoded parameter outputted from the monaural encoding section.

5. The scalable encoding apparatus according to claim 1, wherein:

the monaural encoding section is adapted to output a CELP encoded parameter obtained by searching an adaptive excitation codebook for the monaural speech signal to the first channel encoding section; and
the first channel encoding section is adapted to encode a difference between the parameter obtained by searching the adaptive excitation codebook for the first channel signal, and the CELP encoded parameter outputted from the monaural encoding section.

6. The scalable encoding apparatus according to claim 1, wherein:

the monaural encoding section is adapted to output a fixed excitation codebook index obtained by searching a fixed excitation codebook for the monaural speech signal to the first channel encoding section; and
the first channel encoding section is adapted to use the fixed excitation codebook index outputted from the first channel encoding section as a fixed excitation codebook index of the first channel signal.

7. The scalable encoding apparatus according to claim 1, wherein the generating section is adapted to obtain an average of the first channel signal and the second channel signal and to set the average as the monaural speech signal.

8. A scalable decoding apparatus for decoding a speech signal encoded by a scalable encoding apparatus according to claim 1, the scalable decoding apparatus comprising:

a monaural decoding section that is adapted to decode a monaural speech signal using a CELP encoded parameter outputted from a monaural encoding section;
a first channel decoding section that is adapted to decode a first channel signal of a stereo speech signal using a CELP encoded parameter outputted from a first channel encoding section; and
a second channel decoding section that is adapted to decode a second channel signal of the stereo speech signal using the monaural speech signal and the first channel signal of the stereo speech signal.

9. A scalable decoding apparatus for decoding a speech signal encoded by a scalable encoding apparatus according to claim 4, the scalable decoding apparatus comprising:

a monaural decoding section that is adapted to decode a monaural speech signal using a CELP encoded parameter outputted from a monaural encoding section;
a first channel decoding section that is adapted to decode a first channel signal of a stereo speech signal using a CELP encoded parameter outputted from the monaural encoding section, and a CELP encoded parameter outputted from a first channel encoding section; and
a second channel decoding section that is adapted to decode a second channel signal of the stereo speech signal using the monaural speech signal and the first channel signal of the stereo speech signal.

10. A scalable decoding apparatus for decoding a speech signal encoded by a scalable encoding apparatus according to claim 5, the scalable decoding apparatus comprising:

a monaural decoding section that is adapted to decode a monaural speech signal using a CELP encoded parameter outputted from a monaural encoding section;
a first channel decoding section that is adapted to decode a first channel signal of a stereo speech signal using a CELP encoded parameter outputted from the monaural encoding section, and a CELP encoded parameter outputted from a first channel encoding section; and
a second channel decoding section that is adapted to decode a second channel signal of the stereo speech signal using the monaural speech signal and the first channel signal of the stereo speech signal.

11. A scalable decoding apparatus for decoding a speech signal encoded by a scalable encoding apparatus according to claim 6, the scalable decoding apparatus comprising:

a monaural decoding section that is adapted to decode a monaural speech signal using a CELP encoded parameter outputted from a monaural encoding section;

a first channel decoding section that is adapted to decode a first channel signal of a stereo speech signal using a CELP encoded parameter outputted from the monaural encoding section, and a CELP encoded parameter outputted from a first channel encoding section; and

a second channel decoding section that is adapted to decode a second channel signal of the stereo speech signal using the monaural speech signal and the first channel signal of the stereo speech signal.

12. A communication terminal apparatus comprising the scalable encoding apparatus according to claim 1.

13. A communication terminal apparatus comprising the scalable decoding apparatus according to claim 8.

14. A base station apparatus comprising the scalable encoding apparatus according to claim 1.

15. A base station apparatus comprising the scalable decoding apparatus according to claim 8.

16. A scalable encoding method comprising:

a generating step of generating a monaural speech signal from a stereo speech signal that includes a first channel signal and a second channel signal;

a monaural encoding step of encoding the monaural speech signal using a CELP method;

a calculating step of generating a synthesized second channel signal using a synthesized monaural signal provided by the monaural encoding step and a synthesized first channel signal, calculating a difference between the second channel signal and the synthesized second channel signal and thereby calculating encoding distortion of the second channel signal that is caused by the CELP method used in the monaural encoding step; and

a first channel encoding step of encoding the first channel signal using the CELP method and obtaining a CELP encoded parameter of the first channel signal so as to minimize the sum of the encoding distortion of the first channel signal that is caused by the CELP method used in the first channel encoding step, and the encoding distortion of the second channel signal calculated by the calculating step.

17. A scalable decoding method for decoding a speech signal encoded by the scalable encoding method according to claim 16, the scalable decoding method comprising:

a monaural decoding step of decoding a monaural speech signal using a CELP encoded parameter generated in the monaural encoding step;

a first channel decoding step of decoding a first channel signal of a stereo speech signal using a CELP encoded parameter generated in the first channel encoding step; and

a second channel decoding step of decoding a second channel signal of the stereo speech signal using the monaural speech signal and the first channel signal of the stereo speech signal.

**Patentansprüche**

1. Vorrichtung zum skalierbaren Codieren, die umfasst:

einen Erzeugungsabschnitt, der so eingerichtet ist, dass er ein monophones Sprachsignal aus einem stereophonen Sprachsignal generiert, das ein erstes Kanalsignal und ein zweites Kanalsignal enthält;

einen Monophon-Codierabschnitt, der so eingerichtet ist, dass er das monophone Sprachsignal unter Verwendung eines CELP-Verfahrens codiert;

einen Berechnungsabschnitt, der so eingerichtet ist, dass er ein synthetisiertes zweites Kanalsignal unter Verwendung eines synthetisierten monophonen Signals, das durch den Monophon-Codierabschnitt bereitgestellt wird, und eines synthetisierten ersten Kanalsignals generiert, um eine Differenz zwischen dem zweiten Kanalsignal und dem synthetisierten zweiten Kanalsignal zu berechnen und so Codierverzerrung des zweiten Kanalsignals zu berechnen, die durch das CELP-Verfahren verursacht wird, das in dem Monophon-Codierabschnitt angewendet wird; und

einen ersten Kanal-Codierabschnitt, der so eingerichtet ist, dass er das erste Kanalsignal unter Verwendung des CELP-Verfahrens codiert und einen CELP-codierten Parameter des ersten Kanalsignals generiert, um die Summe der Codierverzerrung des ersten Kanalsignals, die durch das CELP-Verfahren verursacht wird, das in dem ersten Kanal-Codierabschnitt angewendet wird, und der der durch den Berechnungsabschnitt berechneten Codierverzerrung des zweiten Kanalsignals zu minimieren.

2. Vorrichtung zum skalierbaren Codieren nach Anspruch 1, wobei:

der Monophon-Codierabschnitt so eingerichtet ist, dass er das synthetisierte monophone Signal unter Verwendung eines codierten Parameters generiert, der erzeugt wird, indem das monophone Sprachsignal unter Verwendung des CELP-Verfahrens codiert wird;
der erste Kanal-Codierabschnitt so eingerichtet ist, dass er ein synthetisiertes erstes Kanalsignal unter Verwendung des CELP-codierten Parameters generiert, der erzeugt wird, indem das erste Kanalsignal unter Verwendung des CELP-Verfahrens codiert wird.

3. Vorrichtung zum skalierbaren Codieren nach Anspruch 1, wobei die Summe eine Summe der gewichteten Verzerrung der Codierverzerrung des ersten Kanalsignals und der Codierverzerrung des zweiten Kanalsignals ist.

4. Vorrichtung zum skalierbaren Codieren nach Anspruch 1, wobei:

der Monophon-Codierabschnitt so eingerichtet ist, dass er einen CELP-codierten Parameter, der erzeugt wird, indem lineare Prädiktionsanalyse des monophonen Sprachsignals durchgeführt wird, an den ersten Kanal-Codierabschnitt ausgibt; und
der erste Kanal-Codierabschnitt so eingerichtet ist, dass er eine Differenz zwischen dem CELP-codierten Parameter, der erzeugt wird, indem lineare Prädiktionsanalyse des ersten Kanalsignals durchgeführt wird, und dem von dem Monophon-Codierabschnitt ausgegebenen CELP-codierten Parameter codiert.

5. Vorrichtung zum skalierbaren Codieren nach Anspruch 1, wobei:

der Monophon-Codierabschnitt so eingerichtet ist, dass er einen CELP-codierten Parameter, der erzeugt wird, indem ein adaptives Anregungs-Codebuch für das monophone Sprachsignal durchsucht wird, an den ersten Kanal-Codierabschnitt ausgibt; und
der erste Kanal-Codierabschnitt so eingerichtet ist, dass er eine Differenz zwischen dem Parameter, der erzeugt wird, indem das adaptive Anregungs-Codebuch für das erste Kanalsignal durchsucht wird, und dem von dem Monophon-Codierabschnitt ausgegebenen CELP-codierten Parameter codiert.

6. Vorrichtung zum skalierbaren Codieren nach Anspruch 1, wobei:

der Monophon-Codierabschnitt so eingerichtet ist, dass er einen unveränderlichen Anregungs-Codebuch-Index, der erzeugt wird, indem ein unveränderliches Anregungs-Codebuch für das monophone Sprachsignal durchsucht wird, an den ersten Kanal-Codierabschnitt ausgibt; und
der erste Kanal-Codierabschnitt so eingerichtet ist, dass er den unveränderlichen Anregungs-Codebuch-Index, der von dem ersten Kanal-Codierabschnitt ausgegeben wird, als einen unveränderlichen Anregungs-Codebuch-Index des ersten Kanalsignals verwendet.

7. Vorrichtung zum skalierbaren Codieren nach Anspruch 1, wobei der Erzeugungsabschnitt so eingerichtet ist, dass er einen Mittelwert des ersten Kanalsignals und des zweiten Kanalsignals erzeugt und den Mittelwert als das monophone Sprachsignal festlegt.

8. Vorrichtung zum skalierbaren Decodieren zum Decodieren eines mit einer Vorrichtung zum skalierbaren Codieren nach Anspruch 1 codierten Sprachsignals, wobei die Vorrichtung zum skalierbaren Decodieren umfasst:

einen Monophon-Decodierabschnitt, der so eingerichtet ist, dass er ein monophones Sprachsignal unter Verwendung eines von einem Monophon-Codierabschnitt ausgegebenen CELP-codierten Parameters decodiert;
einen ersten Kanal-Decodierabschnitt, der so eingerichtet ist, dass er ein erstes Kanalsignal eines stereophonen Sprachsignals unter Verwendung eines von einem ersten Kanal-Codierabschnitt ausgegebenen CELP-codierten Parameters decodiert; und
einen zweiten Kanal-Decodierabschnitt, der so eingerichtet ist, dass er ein zweites Kanalsignal des stereophonen Sprachsignals unter Verwendung des monophonen Sprachsignals und des ersten Kanalsignals des stereophonen Sprachsignals decodiert.

9. Vorrichtung zum skalierbaren Decodieren zum Decodieren eines mit einer Vorrichtung zum skalierbaren Codieren nach Anspruch 4 codierten Sprachsignals, wobei die Vorrichtung zum skalierbaren Decodieren umfasst:

einen Monophon-Decodierabschnitt, der so eingerichtet ist, dass er ein monophones Sprachsignal unter Verwendung eines von einem Monophon-Codierabschnitt ausgegebenen CELP-codierten Parameters decodiert;
einen ersten Kanal-Decodierabschnitt, der so eingerichtet ist, dass er ein erstes Kanalsignal eines stereophonen Sprachsignals unter Verwendung eines von dem Monophon-Codierabschnitt ausgegebenen CELP-codierten Parameters, und eines von einem ersten Kanal-Codierabschnitt ausgegebenen CELP-codierten Parameters decodiert; und
einen zweiten Kanal-Decodierabschnitt, der so eingerichtet ist, dass er ein zweites Kanalsignal des stereophonen Sprachsignals unter Verwendung des monophonen Sprachsignals und des ersten Kanalsignals des stereophonen Sprachsignals decodiert.

10. Vorrichtung zum skalierbaren Decodieren zum Decodieren eines mit einer Vorrichtung zum skalierbaren Codieren nach Anspruch 5 codierten Sprachsignals, wobei die Vorrichtung zum skalierbaren Decodieren umfasst:

einen Monophon-Decodierabschnitt, der so eingerichtet ist, dass er ein monophones Sprachsignal unter Verwendung eines von einem Monophon-Codierabschnitt ausgegebenen CELP-codierten Parameters decodiert;
einen ersten Kanal-Decodierabschnitt, der so eingerichtet ist, dass er ein erstes Kanalsignal eines stereophonen Sprachsignals unter Verwendung eines von dem Monophon-Codierabschnitt ausgegebenen CELP-codierten Parameters und eines von einem ersten Kanal-Codierabschnitt ausgegebenen CELP-codierten Parameters decodiert; und
einen zweiten Kanal-Decodierabschnitt, der so eingerichtet ist, dass er ein zweites Kanalsignal des stereophonen Sprachsignals unter Verwendung des monophonen Sprachsignals und des ersten Kanalsignals des stereophonen Sprachsignals decodiert.

11. Vorrichtung zum skalierbaren Decodieren zum Decodieren eines mit einer Vorrichtung zum skalierbaren Codieren nach Anspruch 6 codierten Sprachsignals, wobei die Vorrichtung zum skalierbaren Decodieren umfasst:

einen Monophon-Decodierabschnitt, der so eingerichtet ist, dass er ein monophones Sprachsignal unter Verwendung eines von einem Monophon-Codierabschnitt ausgegebenen CELP-codierten Parameters decodiert;
einen ersten Kanal-Decodierabschnitt, der so eingerichtet ist, dass er ein erstes Kanalsignal eines stereophonen Sprachsignals unter Verwendung eines von dem Monophon-Decodierabschnitt ausgegebenen CELP-codierten Parameters und eines von einem ersten Kanal-Codierabschnitt ausgegebenen CELP-codierten Parameters decodiert; und
einen zweiten Kanal-Decodierabschnitt, der so eingerichtet ist, dass er ein zweites Kanalsignal des stereophonen Sprachsignals unter Verwendung des monophonen Sprachsignals und des ersten Kanalsignals des stereophonen Sprachsignals decodiert.

12. Kommunikations-Endgerätvorrichtung, die eine Vorrichtung zum skalierbaren Codieren nach Anspruch 1 umfasst.

13. Kommunikations-Endgerätvorrichtung, die eine Vorrichtung zum skalierbaren Decodieren nach Anspruch 8 umfasst.

14. Basisstationsvorrichtung, die die Vorrichtung zum skalierbaren Codieren nach Anspruch 1 umfasst.

15. Basisstationsvorrichtung, die die Vorrichtung zum skalierbaren Decodieren nach Anspruch 8 umfasst.

16. Verfahren zum skalierbaren Codieren, das umfasst:

einen Erzeugungsschritt des Erzeugens eines monophonen Sprachsignals aus einem stereophonen Sprachsignal, das ein erstes Kanalsignal und ein zweites Kanalsignal enthält;
einen Monophon-Codierschritt des Codierens des monophonen Sprachsignals unter Verwendung eines CELP-Verfahrens;
einen Berechnungsschritt des Generierens eines synthetisierten zweiten Kanalsignals unter Verwendung eines synthetisierten monophonen Signals, das durch den Monophon-Codierschritt bereitgestellt wird, und eines synthetisierten ersten Kanalsignals, des Berechnens einer Differenz zwischen dem zweiten Kanalsignal und dem synthetisierten zweiten Kanalsignal und damit Berechnens von Codierverzerrung des zweiten Kanalsignals, die durch das in dem Monophon-Codierschritt angewendete CELP-Verfahren verursacht wird; und

einen ersten Kanal-Codierschritt des Codierens des ersten Kanalsignals unter Verwendung des CELP-Verfahrens und des Erzeugens eines CELP-codierten Parameters des ersten Kanalsignals, um die Summe der Codierverzerrung des ersten Kanalsignals, die durch das in dem ersten Kanal-Codierschritt angewendete CELP-Verfahren verursacht wird, und der mit dem Berechnungsschritt berechneten Codierverzerrung des zweiten Kanalsignals zu minimieren.

**17.** Verfahren zum skalierbaren Decodieren, mit dem ein mit dem Verfahren zum skalierbaren Codieren nach Anspruch 16 codiertes Sprachsignal decodiert wird, wobei das Verfahren zum skalierbaren Decodieren umfasst:

einen Monophon-Decodierschritt des Decodierens eines monophonen Sprachsignals unter Verwendung eines in dem Monophon-Codierschritt generierte CELP-codierten Parameters;
einen ersten Kanal-Decodierschritt des Decodierens eines ersten Kanalsignals eines stereophonen Sprachsignals unter Verwendung eines in dem ersten Kanal-Codierschritt generierten CELP-codierten Parameters; und
einen zweiten Kanal-Decodierschritt des Decodierens eines zweiten Kanalsignals des stereophonen Sprachsignals unter Verwendung des monophonen Sprachsignals und des ersten Kanalsignals des stereophonen Sprachsignals.

**Revendications**

**1.** Appareil de codage échelonnable comprenant:

une section de génération qui est adaptée pour générer un signal vocal monaural à partir d'un signal vocal stéréo qui comprend un premier signal de canal et un deuxième signal de canal;
une section de codage monaural qui est adaptée pour coder le signal vocal monaural en utilisant un procédé CELP;
une section de calcul qui est adaptée pour générer un deuxième signal de canal synthétisé en utilisant un signal monaural synthétisé fourni par la section de codage monaural et un premier signal de canal synthétisé, afin de calculer une différence entre le deuxième signal de canal et le deuxième signal de canal synthétisé, et ainsi calculer une distorsion de codage du deuxième signal de canal qui est provoquée par le procédé CELP utilisé dans la section de codage monaural; et
une première section de codage de canal qui est adaptée pour coder le premier signal de canal en utilisant le procédé CELP et pour obtenir un paramètre codé par CELP du premier signal de canal de sorte à minimiser la somme de la distorsion de codage du premier signal de canal qui est provoquée par le procédé CELP utilisé dans la première section de codage de canal, et la distorsion de codage du deuxième signal de canal calculée par la section de calcul.

**2.** Appareil de codage échelonnable selon la revendication 1, dans lequel:

la section de codage monaural est adaptée pour générer le signal monaural synthétisé en utilisant un paramètre codé obtenu en codant le signal vocal monaural en utilisant le procédé CELP;
la première section de codage de canal est adaptée pour générer un premier signal de canal synthétisé en utilisant le paramètre codé par CELP obtenu en codant le premier signal de canal en utilisant le procédé CELP.

**3.** Appareil de codage échelonnable selon la revendication 1, dans lequel la somme est une somme de la distorsion pondérée de la distorsion de codage du premier signal de canal et de la distorsion de codage du deuxième signal de canal.

**4.** Appareil de codage échelonnable selon la revendication 1, dans lequel:

la section de codage monaural est adaptée pour faire sortir un paramètre codé par CELP obtenu en effectuant une analyse de prédiction linéaire sur le signal vocal monaural à la première section de codage du canal; et
la première section de codage de canal est adaptée pour coder une différence entre le paramètre codé par CELP obtenu en effectuant une analyse de prédiction linéaire sur le premier signal de canal, et le paramètre codé par CELP sorti depuis la section de codage monaural.

**5.** Appareil de codage échelonnable selon la revendication 1, dans lequel:

la section de codage monaural est adaptée pour faire sortir un paramètre codé par CELP obtenu en cherchant un livre de codes d'excitation adaptative pour le signal vocal monaural à la première section de codage du canal; et

la première section de codage de canal est adaptée pour coder une différence entre le paramètre obtenu en cherchant le livre de codes d'excitation adaptative pour le premier signal de canal, et le paramètre codé par CELP sorti depuis la section de codage monaural.

6. Appareil de codage échelonnable selon la revendication 1, dans lequel:

la section de codage monaural est adaptée pour faire sortir un indice du livre de codes d'excitation fixe obtenu en cherchant un livre de codes d'excitation fixe pour le signal vocal monaural à la première section de codage du canal; et

la première section de codage du canal est adaptée pour utiliser l'indice du livre de codes d'excitation fixe sorti depuis la première section de codage de canal comme étant un indice du livre de codes d'excitation fixe du premier signal de canal.

7. Appareil de codage échelonnable selon la revendication 1, dans lequel la section de génération est adaptée pour obtenir une moyenne du premier signal de canal et du deuxième signal de canal et pour établir la moyenne comme étant le signal vocal monaural.

8. Appareil de décodage échelonnable pour décoder un signal vocal codé par un appareil de codage échelonnable selon la revendication 1, l'appareil de décodage échelonnable comprenant:

une section de décodage monaural qui est adaptée pour décoder un signal vocal monaural en utilisant un paramètre codé par CELP sorti depuis une section de codage monaural.

une première section de décodage de canal qui est adaptée pour décoder un premier signal de canal d'un signal vocal stéréo en utilisant un paramètre codé par CELP sorti depuis une première section de codage de canal; et

une deuxième section de décodage de canal qui est adaptée pour décoder un deuxième signal de canal du signal vocal stéréo en utilisant le signal vocal monaural et le premier signal de canal du signal vocal stéréo.

9. Appareil de décodage échelonnable pour décoder un signal vocal codé par un appareil de codage échelonnable selon la revendication 4, l'appareil de décodage échelonnable comprenant:

une section de décodage monaural qui est adaptée pour décoder un signal vocal monaural en utilisant un paramètre codé par CELP sorti depuis une section de codage monaural;

une première section de décodage de canal qui est adaptée pour décoder un premier signal de canal d'un signal vocal stéréo en utilisant un paramètre codé par CELP sorti depuis la section de codage monaural, et un paramètre codé par CELP sorti depuis une première section de codage de canal; et

une deuxième section de décodage de canal qui est adaptée pour décoder un deuxième signal de canal du signal vocal stéréo en utilisant le signal vocal monaural et le premier signal de canal du signal vocal stéréo.

10. Appareil de décodage échelonnable pour décoder un signal vocal codé par un appareil de codage échelonnable selon la revendication 5, l'appareil de décodage échelonnable comprenant:

une section de décodage monaural qui est adaptée pour décoder un signal vocal monaural en utilisant un paramètre codé par CELP sorti depuis une section de codage monaural;

une première section de décodage de canal qui est adaptée pour décoder un premier signal de canal d'un signal vocal stéréo en utilisant un paramètre codé par CELP sorti depuis la section de codage monaural, et un paramètre codé par CELP sorti depuis une première section de codage de canal; et

une deuxième section de décodage de canal qui est adaptée pour décoder un deuxième signal de canal du signal vocal stéréo en utilisant le signal vocal monaural et le premier signal de canal du signal vocal stéréo.

11. Appareil de décodage échelonnable pour décoder un signal vocal codé par un appareil de codage échelonnable selon la revendication 6, l'appareil de décodage échelonnable comprenant:

une section de décodage monaural qui est adaptée pour décoder un signal vocal monaural en utilisant un paramètre codé par CELP sorti depuis une section de codage monaural;

une première section de décodage de canal qui est adaptée pour décoder un premier signal de canal d'un signal vocal stéréo en utilisant un paramètre codé par CELP sorti depuis la première section de codage monaural, et un paramètre codé par CELP sorti depuis une première section de codage de canal; et

une deuxième section de décodage de canal qui est adaptée pour décoder un deuxième signal de canal du signal vocal stéréo en utilisant le signal vocal monaural et le premier signal de canal du signal vocal stéréo.

12. Appareil de terminal de communication comprenant l'appareil de codage échelonnable selon la revendication 1.

13. Appareil de terminal de communication comprenant l'appareil de décodage échelonnable selon la revendication 8.

14. Appareil de station de base comprenant l'appareil de codage échelonnable selon la revendication 1.

15. Appareil de station de base comprenant l'appareil de décodage échelonnable selon la revendication 8.

16. Procédé de codage échelonnable comprenant:

une étape de génération pour générer un signal vocal monaural depuis un signal vocal stéréo qui comprend un premier signal de canal et un deuxième signal de canal;
une étape de codage monaural qui consiste à coder le signal vocal monaural en utilisant un procédé CELP;
une étape de calcul qui consiste à générer un deuxième signal de canal synthétisé en utilisant un signal monaural synthétisé fourni par l'étape de codage monaural et un premier signal de canal synthétisé, à calculer une différence entre le deuxième signal de canal et le deuxième signal de canal synthétisé et calculer ainsi une distorsion de codage du deuxième signal de canal qui est provoquée par le procédé CELP utilisé à l'étape de codage monaural, et
une première étape de codage de canal qui consiste à coder le premier signal de canal en utilisant le procédé CELP et à obtenir un paramètre codé par CELP du premier signal de canal de sorte à minimiser la somme de la distorsion de codage du premier signal de canal qui est provoquée par le procédé CELP utilisé à la première étape de codage de canal, et la distorsion de codage du deuxième signal de canal calculée par l'étape de calcul.

17. Procédé de décodage échelonnable pour décoder un signal vocal codé par le procédé de codage échelonnable selon la revendication 16, le procédé de décodage échelonnable comprenant:

une étape de décodage monaural pour décoder un signal vocal monaural en utilisant un paramètre codé par CELP généré à l'étape de codage monaural;
une première étape de décodage de canal pour décoder un premier signal de canal d'un signal vocal stéréo en utilisant un paramètre codé par CELP généré à la première étape de codage de canal; et
une deuxième étape de décodage de canal pour décoder un deuxième signal de canal du signal vocal stéréo en utilisant le signal vocal monaural et le premier signal de canal du signal vocal stéréo.

FIG.1

ENCODING

⟹

FIRST
CHANNEL SIGNAL
CH1

FIRST CHANNEL
SIGNAL DIFFERENCE
ΔCH1

FIRST CHANNEL
SIGNAL DIFFERENCE
ΔCH1

MONAURAL
SIGNAL M

SECOND CHANNEL
SIGNAL DIFFERENCE
ΔCH2

SECOND CHANNEL
SIGNAL DIFFERENCE
ΔCH2

SECOND
CHANNEL SIGNAL
CH2

FIG.2A

FIG.2B

EP 1 801 783 B1

FIG.3

FIRST CHANNEL
SIGNAL
CH1

LPC ANALYZING
SECTION
131

ADAPTIVE
EXCITATION
CODEBOOK
137

138

LPC QUANTIZING
SECTION
132

CELP ENCODED
PARAMETER OF FIRST
CHANNEL SIGNAL ($C_L$)

ADAPTIVE
EXCITATION GAIN

142

133

134

LPC
SYNTHESIS
FILTER

FIXED
EXCITATION
CODEBOOK
139

140

FIXED EXCITATION
GAIN

CH1

CELP ENCODED
PARAMETER OF FIRST
CHANNEL SIGNAL
($C_A$, $C_D$, $C_G$)

GAIN
CODEBOOK
141

DISTORTION
MINIMIZING
SECTION
136

PERCEPTUAL
WEIGHTING
SECTION
135

CH1-CH1

143 SECOND CHANNEL SIGNAL
ERROR COMPONENT
CALCULATING SECTION

144

CH1

SECOND CHANNEL
SIGNAL
CH2

145

CH2

SECOND CHANNEL
SYNTHESIS SIGNAL
GENERATING SECTION

M'

**FIG.4**

EP 1 801 783 B1

EP 1 801 783 B1

**150** SCALABLE DECODING APPARATUS

FIRST LAYER

151

MONAURAL SIGNAL
CELP DECODER

CELP ENCODED
PARAMETER OF
MONAURAL SIGNAL

M'

SECOND LAYER

CH 1'

152

FIRST CHANNEL
SIGNAL DECODER

153

SECOND CHANNEL
SIGNAL DECODER

CELP ENCODED
PARAMETER OF
FIRST CHANNEL SIGNAL

CH2'

FIG.5

FIG.6

FIG.7

FIRST LAYER

151

MONAURAL SIGNAL CELP DECODER

CELP ENCODED PARAMETER OF MONAURAL SIGNAL

M'

SECOND LAYER

152a

FIRST CHANNEL SIGNAL DECODER

CELP ENCODED PARAMETER OF FIRST CHANNEL SIGNAL

153

SECOND CHANNEL SIGNAL DECODER

CH 1'

CH2'

FIG.8

EP 1 801 783 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0223529 A1